# EUROPEAN PATENT APPLICATION

(11) **EP 4 403 537 A1**
(43) Date of publication of application: **24.07.2024**
(21) Application number: 24152806.6
(22) Date of filing: 19.01.2024
(51) Int. Cl.: C04B 35/573, C04B 37/00, C04B 41/00, C04B 41/45, C04B 41/50, C04B 41/87, G02B 5/08

(54) **INFILTRATION BONDED CVD DIAMOND TO REACTION BONDED DIAMOND + SIC COMPOSITE**

(30) Priority: 23.01.2023 US 202318158333
(71) Applicant: II-VI Delaware, Inc., Wilmington, DE 19890 (US)
(72) Inventor: Marshall, Andrew, Wilmington, 19890 (US); Evans, Glenn, Wilmington, 19890 (US); Salamone, Samuel, Wilmington, 19890 (US)
(74) Representative: Tegethoff, Sebastian

(57) **Abstract**

Disclosed herein are bonded diamond composites that may include a ceramic composite layer, a diamond film layer, and a silicon carbide bonding layer bonding the diamond film layer to the ceramic composite layer. Example ceramic composite layers disclosed herein include diamond particles within a silicon carbide matrix. Methods of making bonded diamond composites through infiltration bonding are disclosed herein. Example methods include exposing a ceramic preform to molten silicon such that the silicon infiltrates into and through the silicon preform to a diamond film interfaced with the ceramic preform. Example methods include reacting the silicon with the ceramic preform and the diamond film to form a silicon carbide bonding layer bonding the diamond film to the resulting ceramic composite layer.

## Description

### Field of the Disclosure

The present disclosure relates to bonded diamond composites and methods of bonding a diamond film layer to a ceramic composite layer.

### Brief description of the related art

Diamond is one of the hardest materials known and has excellent properties for use in industrial and optical environments. However, in order to successfully use diamond materials in such environments, diamond particles and diamond films must be mounted and bonded to surfaces.

One prior known method of adhering a diamond film to a surface is to utilize brazing compounds, for example, 4047-F Temper Aluminum. Such brazing compounds can be melted and resolidified between the diamond film to hold the film to the surface. Unfortunately, typical brazing compounds are limited in their thermal cycling range because they typically have different coefficients of thermal expansion from the diamond film and/or mounting surface or will liquify at higher temperatures. Such properties will result in a stressed bond and/or failure.

Disadvantages of the prior art are overcome to a significant extent by the present disclosure.

### Brief Summary of the Disclosure

Disclosed herein are bonded diamond composites including a ceramic composite layer, a diamond film layer, and a silicon carbide bonding layer bonding the diamond film layer to the ceramic composite layer. In one aspect of the disclosure, a ceramic composite layer comprises a plurality of diamond particles bonded together with a matrix comprising silicon carbide. In another aspect of the disclosure, a matrix is connected to the silicon carbide bonding layer. In another aspect of the disclosure, a silicon carbide of a matrix is bonded to the silicon carbide bonding layer.

In one aspect of the disclosure, diamond particles have a median particle diameter (D50) of from about 10 microns to about 120 microns. In another aspect of the disclosure, the ceramic composite layer includes from about 50% to about 75 by volume of the diamond particles. In yet another aspect of the disclosure, a silicon carbide bonding layer is from about 20 microns to about 200 micrometers average thickness as measured between the ceramic composite layer and the diamond film layer. In yet another aspect of the disclosure, a silicon carbide bonding layer includes less than 10% by volume of residual elemental silicon.

Disclosed herein are methods of bonding a diamond film layer to a ceramic composite layer including, placing a diamond film layer onto a ceramic preform, wherein the ceramic preform comprises diamond particles and a carbon containing binder, exposing the ceramic preform to molten silicon, and reacting the molten silicon with the diamond film and the ceramic preform to form a ceramic composite layer and a silicon carbide bonding layer bonding the diamond film to the ceramic composite layer. In one aspect of the disclosure, a ceramic composite layer comprises a plurality of diamond particles bonded together with a matrix comprising silicon carbide. In another aspect of the disclosure, a reacting step converts at least a portion of the diamond film layer into the silicon carbide bonding layer. In yet another aspect of the disclosure, a ceramic preform comprises a carbon containing binder and the reacting step converts at least a portion of the carbon containing binder into silicon carbide.

In one aspect of the disclosure, a ceramic preform further comprises silicon carbide prior to exposing and reacting steps. In another aspect of the disclosure, a reacting step is performed under a vacuum and at an elevated temperature, where pressure is less than about 110 Pascals, absolute, and the elevated temperature is greater than about 1680K. In one aspect of the disclosure, disclosed methods include drawing the molten silicon through the diamond preform towards the diamond film through a capillary action. In another aspect of the disclosure, the exposing step comprising placing the ceramic preform on a preform feeder medium and contacting the preform feeder medium with the molten silicon.

In one aspect of the disclosure, a reacting step is completed for a time period sufficient to convert substantially all of the carbon binder to silicon carbide. In another aspect of the disclosure, the time period is from about 30 minutes to about 10 hours. In yet another aspect of the disclosure, the method utilizes diamond particles that have a median particle diameter (D50) of from about 10 microns to about 120 microns. In one aspect of the disclosure, a ceramic composite layer comprises from about 50% to about 75% by volume of the diamond particle. In another aspect of the disclosure, the disclosed methods produce a silicon carbide bonding layer that is between about 20 microns to about 200 microns average thickness as measured between the ceramic composite layer and the diamond film layer. In yet another aspect of the disclosure, each of the ceramic composite layer and the silicon carbide bonding layer comprises less than about 10% by volume of residual elemental silicon. In another aspect of the disclosure,
the diamond film layer utilized in disclosed methods has a thickness from about 500 microns to about 2300 microns.

### Summary of the Drawings

The invention will be described based on figures. It will be understood that the embodiments and aspects of the invention described in the figures are only examples and do not limit the protective scope of the claims in any way. The invention is defined by the claims and their equivalents. It will be understood that features of one aspect or embodiment of the invention can be combined with a feature of a different aspect or aspects of other embodiments of the invention, in which:
FIG. 1 shows a schematic view of a bonded diamond composite in accordance with disclosed embodiments;
FIG. 2 shows a scanning electron microscope view of a cross section of a bonded diamond composite in accordance with disclosed embodiments;
FIG. 3 shows a method of forming a bonded diamond composite in accordance with disclosed embodiments;
FIGS. 4-6 show schematic representations of intermediate steps of the method of FIG. 3 in accordance with disclosed embodiments; and
FIG. 7 shows a schematic view of a bonded diamond composite in accordance with disclosed embodiments.

### Deatiles description of the disclosure

The technical problem is solved by the independent claims. The dependent claims cover further specific embodiments of the invention.

Disclosed herein are bonded diamond composites and methods of making the same that provide advantageous thermal properties as compared to those in the prior art.

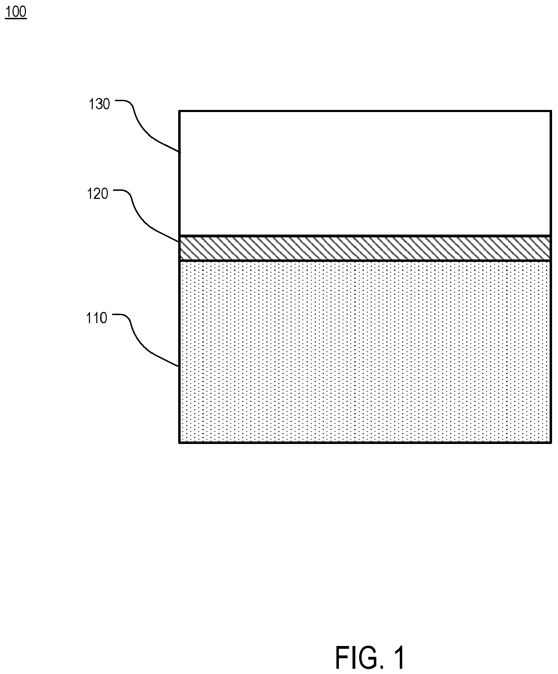

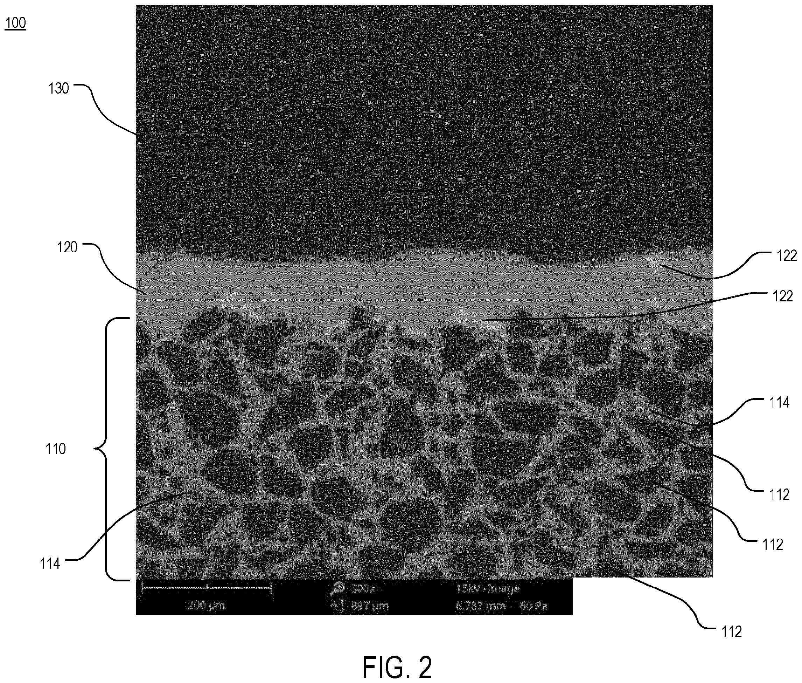

FIGS. 1 and 2 show an example bonded diamond composite 100. Fig. 1 shows a schematic representation of an example bonded diamond composite 100, not drawn to scale. While FIG. 2 shows a scanning electron microscopic image (to scale) of a cross-section of an example bonded diamond composite 100, FIG. 2 only shows a magnified portion of the entire example bonded diamond composite 100. The bonded diamond composite 100, includes, for example, a ceramic composite layer 110, a diamond film layer 130, and a bonding layer 120 bonding the diamond film layer 130 to the ceramic composite layer 110.

The diamond film layer 130 may be any diamond film known in the art, for example a diamond film grown through the use of chemical vapor deposition (CVD) processes. However other processes may also be used. Further, the orientation of the diamond lattice within the film, and the thickness of the diamond film can be varied based on the intended use of the bonded diamond composite 100. For example, some applications such as high energy lasers may require thicker diamond films as compared to applications with lower power density requirements. The diamond film layer (prior to formation of the bonded diamond composite 100 and discussed below as un-bonded diamond film 530) need only be thick enough prior to formation such that diamond film layer 130 remaining after formation of the diamond composite 100 is sufficiently thick for the intended application.

Ceramic composite layer 110 may include, for example, a plurality of diamond particles 112 within a ceramic matrix 114. Ceramic composite layer 110 may also be referred to as a diamond reinforced ceramic matrix. Ceramic matrix 114 may be, for example, mostly silicon carbide, or in another example, substantially all silicon carbide. Some additional trace materials, such as elemental silicon and common silicon impurities may be included in the ceramic matrix 114, which may result from impurities and/or unreacted silicon. The diamond particles 112 may include, for example, diamond particles having a median particle diameter (D50) of about 65 microns. That is, some diamond particles 112 may be a diameter that is larger than 65 microns or smaller than 65 microns, but the median of those diamond particles for a D50 of about 65 microns would be about 65 microns. Other diamond particle sizes may also be used. For example, diamond particles 112 having a D50 of from about 10 microns to about 120 microns. The ceramic composite layer 110 may include, from about 30% to about 70% by volume of diamond particles 112. In an example, the ceramic composite layer 110 may include about 50% by volume of diamond particles 112.

Bonding layer 120 is a ceramic bonding layer bonding the diamond film layer 130 to the ceramic composite layer 110. Bonding layer 120 is both bonded to diamond film layer 130 and to the ceramic composite layer 110, thus attaching diamond film layer 130 to the diamond particles 112 and/or the ceramic matrix 114. Bonding layer 120 may be formed of the same material as ceramic matrix 114. Bonding layer 120 may be, for example, formed of silicon carbide and may be integrated with and/or bonded to a silicon carbide contained within the ceramic matrix 114 forming a strong adhesion to the ceramic composite layer 110. Bonding layer 120 is also bonded to diamond film layer 130 through ceramic - diamond bonding, for example, silicon-carbide to carbon bonding. Bonding layer 120 may be, for example, mostly silicon carbide, or in another example substantially all silicon carbide. Some additional trace materials, such as residual silicon 122 may be included in the bonding layer 120, which may result from impurities and/or unreacted silicon. In one example, the bonding layer contains less than 10% by volume of residual silicon. In another example, the bonding layer contains less than 5% by volume of residual silicon. In another example, the bonding layer contains less than 3% by volume of residual silicon. In another example, the bonding layer contains less than 1% by volume of residual silicon.

The thickness of the bonding layer 120, i.e., the distance between the ceramic composite layer 110 and the diamond film layer 130, can vary depending on the application need. For example, a thinner bonding layer 120 may be used when higher heat transfer from the diamond film layer 130 and the ceramic composite layer 110 is preferred, whereas a thicker bonding layer 120 may be used when higher bonding strength between the diamond film layer 130 and the ceramic composite layer 110 is required. In one example, the bonding layer 120 comprises silicon carbide and has an average thickness of from about 20 microns to about 200 microns as measured between the ceramic composite layer 110 and the diamond film layer 130. For example, the bonding layer 120 may have a thickness of from about 40 microns to about 140 microns, from about 60 microns to about 120 microns, or from about 80 microns to about 100 microns.

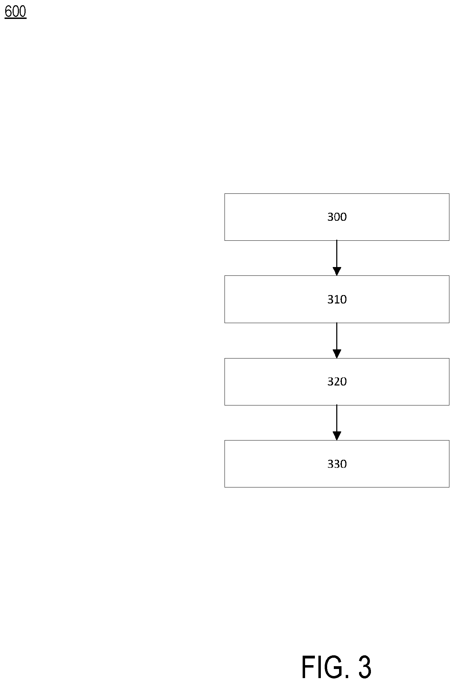

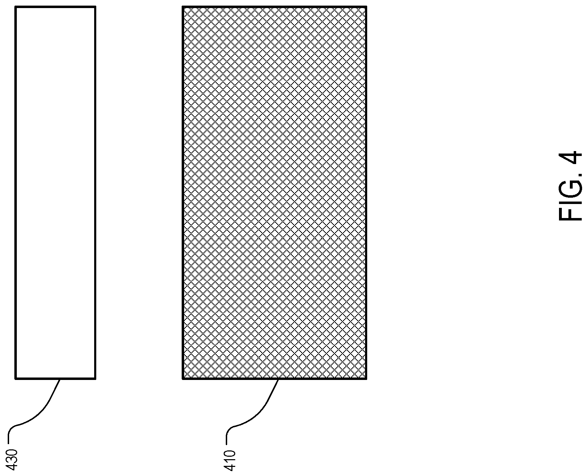

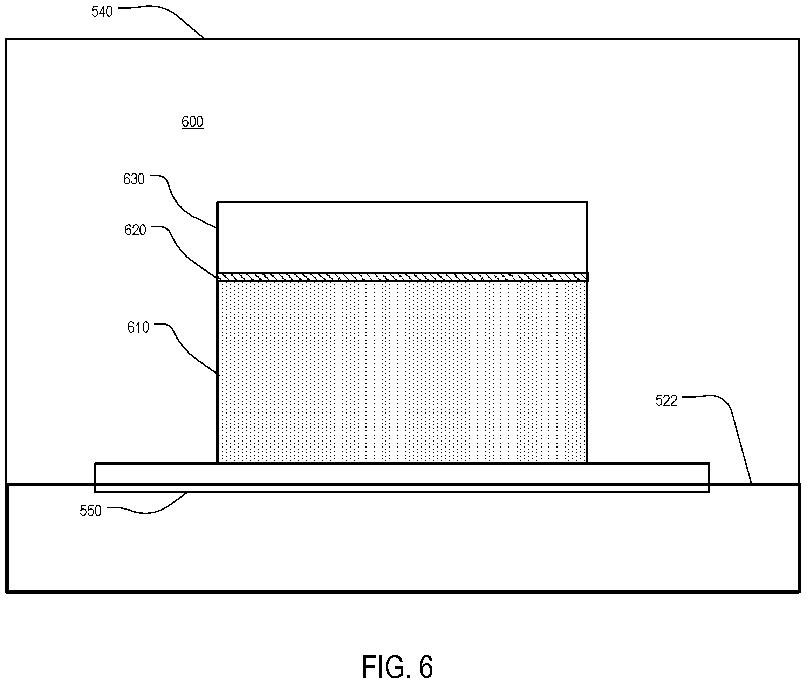

Shown in FIG. 3 is a method 600 of forming a bonded diamond composite 600 (FIG. 6) or a method of bonding a diamond film layer 430 to a ceramic composite layer 410 (FIG. 4), discussed with additional reference to FIGS. 4-6. Bonded diamond composite 600 may be the same or similar to bonded diamond composite 100 described with reference to FIGS. 1 and 2 and characteristics described with reference to bonded diamond composite 100 are equally applicable to bonded diamond composite 600.

At step 300, a diamond film 430 is provided along with a ceramic preform 410 as shown in FIG. 4. The diamond film 430 may be similar to diamond film 130, except that diamond film 430 has not yet been reacted / bonded to the ceramic composite layer 110 and thus may be incrementally thicker than diamond film 130 (FIGS. 1 and 2) or resulting diamond film 630 (FIG. 6). As noted above, diamond film 430 may be a CVD grown diamond film. In one example, the growth side surface of the diamond film 430 is oriented toward the ceramic preform 410, which may be advantageous to the typically increased relative roughness of the growth side as compared to opposite (substrate) side of a CVD grown diamond film, which may contribute to better adhesion and formation of the bonding layer. The growth side surface of the diamond film 430 may also be polished or lapped prior to further processing.

Ceramic preform 410 may be ceramic preforms known in the art, for example those described in US Patent 8,474,362 ("the `362 patent"), which is incorporated by reference herein in its entirety. Ceramic preform 410 may include, for example, a plurality of diamond particles (for example diamond particles 112 (FIGS 1-2)) held together with a carbon comprising binder. The plurality of diamond particles may be the same or similar plurality of diamond particles 112 discussed with reference to FIGS. 1 and 2 because the diamond particles within the ceramic preform 410 will ultimately become the diamond particles within bonded diamond composite 600, but exist in ceramic preform 410 prior to further processing.

The diamond particles within the ceramic preform 410 may include, for example, diamond particles having a D50 of about 75 microns. In other examples, the ceramic preform 410 may include diamond particles having a D50 of from about 10 microns to about 120 microns. The ceramic preform 410 may include, from about 0% to about 75% by volume of diamond particles 112. For example, the ceramic preform 410 may include about 50% by volume of diamond particles. With the remainder being carbon comprising binder and air in the nature of porous voids. The porosity be any porosity to provide adequate capillary draw of molten silicon. In one example, the ceramic preform 410 has a porosity of from about 20% to about 25%. The carbon comprising binder may be any carbon based binder known in the art for making ceramic preforms. However, the binder should have sufficient carbon content such that upon further processing, e.g., the reacting step discussed below, the carbon reacts with the molten silicon to form the silicon carbide within the ceramic matrix 114. The ceramic preform 410 may, in one example, further include silicon carbide prior to the reacting step. That is, when forming the ceramic preform 410 an amount of silicon carbide may be included. For example, from between about 0 and about 75 percent by volume silicon carbide in the ceramic preform 410.

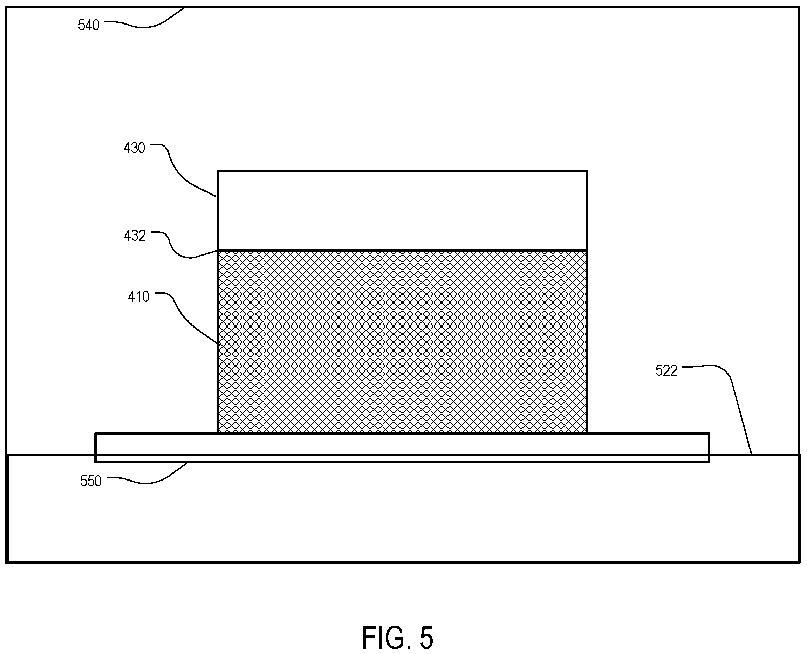

At step 310, the diamond film layer 430 is placed on the ceramic preform 410 as shown in FIG. 5. Optionally, pressure may be applied to the top of diamond film layer 430, i.e., on the opposite side of the diamond film layer 430 from the ceramic preform, to maintain the position of the diamond film layer 430 on the ceramic preform during follow-on steps. A weight (not shown) may be used to supply such pressure. The diamond film layer 430, together with the ceramic preform 410, may be placed in a furnace 540 to control the temperature of the follow-on reactions, discussed below.

At step 320, the ceramic preform 410 is exposed to molten silicon 522, for example within the furnace 540 at a temperature above the melting temperature of silicon for the relevant pressure, i.e., above about [1,410°C] at atmospheric pressure. The furnace 540 may also be a vacuum furnace that is capable of drawing a vacuum below atmospheric pressure, which may aid transporting the molten silicon 522 through the ceramic preform. For example, a pressure less than about 110 Pascals may be applied to furnace 540, where about 101,325 Pascals represents atmospheric pressure and thus 110 Pascals is a reduced absolute pressure compared to atmospheric pressure.

To aid with separation following reaction, a porous preform feeder medium 550 may optionally be used, and optionally sacrificed at completion. The preform feeder medium 550 may be made of any material that is capable of wicking or transferring the molten silicon 550 through capillary action to the ceramic preform. The preform feeder medium 550 may be arranged in such a way that the feeder medium 550 is resting in the molten silicon bath at temperature, with the ceramic preform 410 and the diamond film layer 430 thereon. The molten silicon 522 contacts the preform feeder medium and is wicked through the preform feeder medium 550 to the ceramic preform 410 through capillary action. The ceramic preform 410 likewise wicks the molten silicon 522 throughout the ceramic preform 410 and also to the diamond film layer 430 at the interface 432 between the diamond film layer 430 and the ceramic preform 410. Put differently, the molten silicon infiltrates the ceramic preform to the diamond film layer 430.

At step 320 the molten silicon 522, which is infiltrated throughout the pores of the ceramic preform 410 and at the interface 432, reacts with the carbon within the ceramic preform 410 and the carbon at the interface 432 of the diamond film layer 130. The molten silicon 522 and the carbon in the preform 410 react to form a ceramic matrix similar to that described above with respect to ceramic matrix 114, for example, the molten silicon 522 and the carbon in the preform 410 react to form silicon carbide. Further, some of the molten silicon 522 may also react with the surface of the diamond particles within the ceramic preform 410 to also form silicon carbide. Once the reaction in the ceramic preform 410 is complete, the ceramic preform is now ceramic composite layer 610 (FIG. 6) similar to ceramic composite layer 110 having the diamond particles embedded therein.

The molten silicon 522 also reacts with diamond film layer 430 at interface 432, thus converting a portion of the carbon at the surface of the diamond film layer 430 into silicon carbide. Since diamond is a form of dense carbon, it can react with silicon used in the infiltration process to form a silicon carbide interface. As shown in FIG. 6, the result is a bonded diamond composite 600 having a diamond film layer 630, a ceramic composite layer 610, and a bonding layer 620. Bonded diamond composite 600, diamond film layer 630, ceramic composite layer 610, and bonding layer 620, are each respectively similar to bonded diamond composite 100, diamond film layer 130, ceramic composite layer 110, and bonding layer 120 of FIGS. 1-2, and the features and methods of making are equally applicable to both, respectively.

The length of the reaction time will depend on a number of factors, including the temperature, pressure, and desired thickness of the bonding layer 620. For example, a higher temperature will decrease the amount of reaction time required to form bonding layer 620, while a lower pressure will decrease the temperature required for the reaction. Further, a longer reaction will result in a thicker bonding layer 620. In one example, at a pressure of about 13 Pascals and a temperature of 1780K, a bonding layer 620 having an average thickness of about 100 µm was reacted for about 4 hours. At the completion of the reacting step 320, the bonding layer 620 is bonded to the diamond film layer 630 and bonded / integrated into the ceramic matrix of ceramic matrix of ceramic composite layer 610 forming a strong bond of the diamond film layer 630 to the ceramic composite layer 610.

Upon completion of the reacting step 320, some amount of unreacted residual silicon (e.g., residual silicon 122 shown in FIG. 2) may be present in the bonding layer 620 and/or the ceramic matrix of ceramic composite layer 610. While a certain amount of residual silicon will not materially impact bonding strength of the resulting bonded diamond composite, such residual silicon can optionally be reduced by adding finer diamond in the initial ceramic preform 410.

At step 330, the furnace 540 may be cooled to room temperature, and pressure equalized if under vacuum, and the bonded diamond composite 600 may be removed from the preform feeder medium 550.

The resulting composite, e.g., bonded diamond composite 100 or bonded diamond composite 600, has low thermal expansion, high thermal conductivity (can dissipate heat rapidly), high hardness, high wear resistance, high stiffness, chemical inertness, and can be utilized in a number of industrial wear, thermal management, and optical industries as well as others. For example: (a) for industrial applications: low friction/high wear resistance seals; dry seals impingement surfaces; and cutting tools, (b) for semiconductor applications: dry wafer chucks; wafer chucks with internal cooling; and electrostatic chucks, (c) for defense applications: graded armor materials, (d) for thermal management: heat sinks for lasers; heat sinks for mirrors; high power electrical heat sinks.

The diamond film layers 130, 630 also have similar thermal expansion properties (coefficient of thermal expansion) as the ceramic composite layers 110,610, and the bonding layers 620, 620. Thus, when subjected to heat, there is relatively little stress put on the bonds due to differences in thermal expansion. The bond between diamond film layers 130, 630 and ceramic composite layers 110,610 is also hermetic, and thus, channels and holes opened into the back of the ceramic composite layers 110,610 and or diamond film layers 130,630 are also feasible. This allows for maximum thermal heat dissipation where required. Potential applications include structures that need extreme wear surfaces, low friction surfaces, heat sinks, and structures that require high thermal stability.

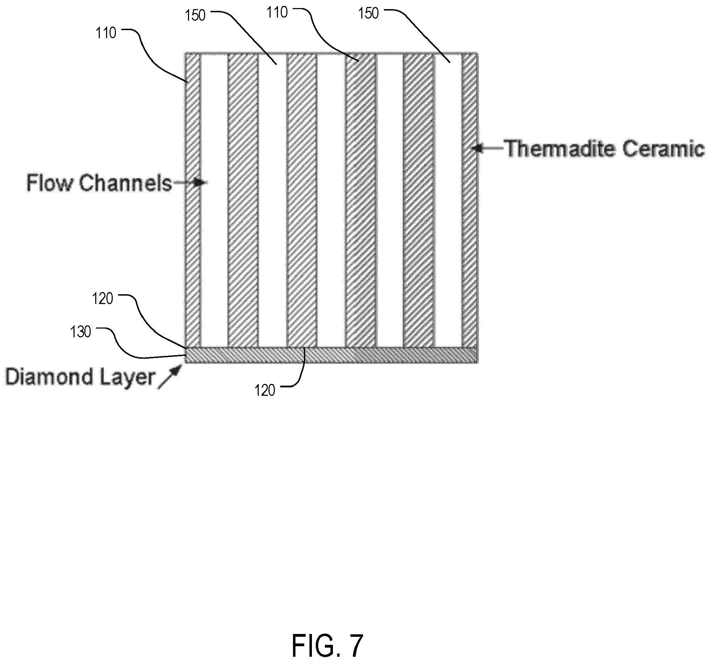

As compared to prior art methods using brazing compounds, the bonded diamond composites 100, 600, including those made using the infiltration bonding process 600 described herein, provide for a shorter and simpler manufacturing process, a lower thermal resistance interface, higher temperature capability interface, and a chemically inert interface for applications in which a reactive cooling medium may be used, for example deionized water. For example, as shown in FIG. 7 is an example bonded diamond composite 100 that includes flow channels 150 in the ceramic composite layer 110 for providing a heat transfer fluid (for either cooling or heating the diamond layer 130). The flow channels 150 may be formed according to typical ceramic shape forming methods. For example, they can be molded in with any of the number of preform manufacturing methods, e.g. sedimentation, slip casting, etc. at the time of manufacturing the ceramic composite layer 110. They may also be added by machining them after the binder burnout firing, for example the carbonizing steps described in the `362 patent, but before the thermal process described with reference to step 320. Such configurations allow direct contact between any fluid within the flow channels 150 and the diamond layer 130 without the disadvantages related to corrosion of the prior art brazing compounds.

## Claims

1. A bonded diamond composite comprising:
- a ceramic composite layer;
- a diamond film layer; and
- a silicon carbide bonding layer bonding the diamond film layer to the ceramic composite layer.

2. The bonded diamond composite of claim 1, wherein the ceramic composite layer comprises a plurality of diamond particles bonded together with a matrix comprising silicon carbide.

3. The bonded diamond composite of claim 2, wherein the matrix is connected to the silicon carbide bonding layer.

4. The bonded diamond composite of claim 2, wherein the silicon carbide of the matrix is bonded to the silicon carbide bonding layer.

5. The bonded diamond composite of claim 1, wherein the diamond particles have a median particle diameter (D50) of from about 10 microns to about 120 microns.

6. The bonded diamond composite of claim 2, wherein the ceramic composite layer comprises from about 50% to about 75% by volume of the diamond particles.

7. The bonded diamond composite of claim 1, wherein the silicon carbide bonding layer is from about 20 microns to about 200 microns average thickness as measured between the ceramic composite layer and the diamond film layer.

8. The bonded diamond composite of claim 1, wherein the silicon carbide bonding layer comprises less than 10% by volume of residual elemental silicon.

9. A method of bonding a diamond film layer to a ceramic composite layer, the method comprising:
- placing a diamond film layer onto a ceramic preform, wherein the ceramic preform comprises diamond particles and a carbon containing binder;
- exposing the ceramic preform to molten silicon; and
- reacting the molten silicon with the diamond film and the ceramic preform to form a ceramic composite layer and a silicon carbide bonding layer bonding the diamond film to the ceramic composite layer.

10. The method of claim 9, wherein the ceramic composite layer comprises a plurality of diamond particles bonded together with a matrix comprising silicon carbide.

11. The method of claim 9, wherein the reacting step converts at least a portion of the diamond film layer into the silicon carbide bonding layer.

12. The method of claim 9, wherein the ceramic preform comprises a carbon containing binder and the reacting step converts at least a portion of the carbon containing binder into silicon carbide.

13. The method of claim 9, wherein the ceramic preform further comprises silicon carbide prior to exposing and reacting steps.

14. The method of claim 9, wherein the reacting step is performed under a vacuum and at an elevated temperature, wherein the pressure is less than about 110 Pascals, absolute, and the elevated temperature is greater than about 1680K.

15. The method of claim 9, further comprising drawing the molten silicon through the diamond preform towards the diamond film through a capillary action.

16. The method of claim 9, wherein the exposing step comprises placing the ceramic preform on a preform feeder medium and contacting the preform feeder medium with the molten silicon.

17. The method of claim 11, wherein the reacting step is completed for a time period sufficient to convert substantially all of the carbon binder to silicon carbide.

18. The method of claim 17, wherein the time period is from about 30 minutes to about 10 hours.

19. The method of claim 9, wherein the diamond particles have a median particle diameter (D50) of from about 10 microns to about 120 microns.

20. The method of claim 10, wherein the ceramic composite layer comprises from about 50% to about 75% by volume of the diamond particle.

21. The method of claim 12, wherein the silicon carbide bonding layer is between about 20 microns to about 200 microns average thickness as measured between the ceramic composite layer and the diamond film layer.

22. The method of claim 12, wherein each of the ceramic composite layer and the silicon carbide bonding layer comprises less than about 10% by volume of residual elemental silicon.

23. The method of claim 9, wherein the diamond film layer has a thickness from about 500 microns to about 2300 microns.
